(19) Europäisches Patentamt
European Patent Office
Office européen des brevets

(11) EP 4 318 091 A1

(12) EUROPEAN PATENT APPLICATION
published in accordance with Art. 153(4) EPC

(43) Date of publication:
**07.02.2024 Bulletin 2024/06**

(21) Application number: **21935241.6**

(22) Date of filing: **28.12.2021**

(51) International Patent Classification (IPC):
***G02C 7/00*** (2006.01) ***C23C 14/12*** (2006.01)
***C23C 14/14*** (2006.01) ***G02B 1/115*** (2015.01)
***G02B 1/18*** (2015.01)

(52) Cooperative Patent Classification (CPC):
**C23C 14/08; C23C 14/12; C23C 14/14; G02B 1/113; G02B 1/115; G02B 1/14; G02B 1/18; G02C 7/00**

(86) International application number:
**PCT/JP2021/048731**

(87) International publication number:
**WO 2022/209094 (06.10.2022 Gazette 2022/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **30.03.2021 JP 2021058172**

(71) Applicant: **Hoya Lens Thailand Ltd.**
**Pathumthani 12130 (TH)**

(72) Inventor: **NOMURA Takumi**
**Tokyo 160-8347 (JP)**

(74) Representative: **Hoffmann Eitle**
**Patent- und Rechtsanwälte PartmbB**
**Arabellastraße 30**
**81925 München (DE)**

# (54) EYEGLASS LENS, MANUFACTURING METHOD FOR EYEGLASS LENS, AND EYEGLASSES

(57) There is provided a spectacle lens including a lens substrate and an inorganic layer, and further including a metal-containing layer on the side of the surface of the inorganic layer opposite to the lens substrate, wherein a metal contained in the metal-containing layer includes a first metal and a second metal, the first metal is silver, and the second metal is one or more metals selected from the group consisting of cobalt, nickel, zinc, copper, zirconium, molybdenum, lead, platinum, gold and palladium.

[Fig. 1]

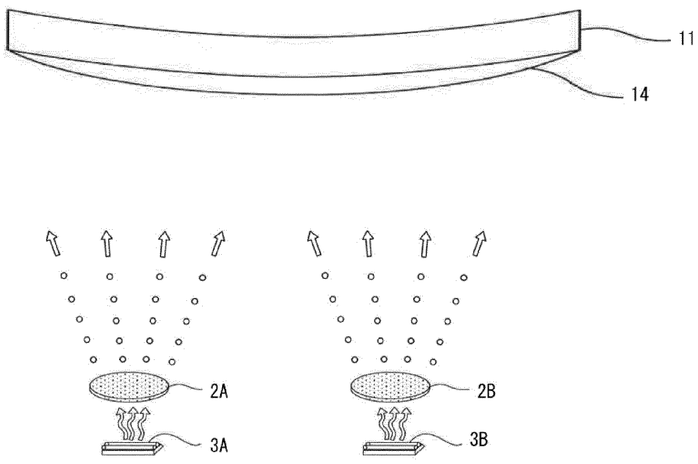


EP 4 318 091 A1

## Description

[Technical Field]

The present invention relates to a method of producing a spectacle lens and spectacles.

[Background Art]

A spectacle lens generally has a configuration in which one or more functional layers are formed on the surface of a lens substrate (for example, refer to PTL 1).

[Citation List]

[Patent Literature]

[PTL 1] Japanese Patent Application Publication No. 2003-14904

[Summary of Invention]

[Technical Problem]

In recent years, the need for antibacterial materials has increased. Under such circumstances, if a function through which proliferation of bacteria can be restricted (that is, an antibacterial property) is imparted to spectacle lenses, the added value of the spectacle lenses can be increased.

In addition, spectacle lenses are exposed to light and water during long term use when they are incorporated into spectacles and used by spectacle wearers. Therefore, it is desirable for the spectacle lenses to have excellent light-resistant and water-resistant antibacterial properties.

An object of one aspect of the present invention is to provide a spectacle lens having excellent light-resistant and water-resistant antibacterial properties.

[Solution to Problem]

One aspect of the present invention relates to a spectacle lens including a lens substrate and an inorganic layer, and further including a metal-containing layer on the side of the surface of the inorganic layer opposite to the lens substrate, wherein a metal contained in the metal-containing layer includes a first metal and a second metal, wherein the first metal is silver, and wherein the second metal is one or more metals selected from the group consisting of cobalt, nickel, zinc, copper, zirconium, molybdenum, lead, platinum, gold and palladium.

The metal-containing layer can function as an antibacterial layer for imparting antibacterial properties to the spectacle lens. When such a layer is provided, the spectacle lens can exhibit an antibacterial property. Regarding the antibacterial properties, silver contained as the first metal can function as an antibacterial component. It is speculated that the second metal can contribute to controlling the progress of oxidation of silver and improving light resistance and water resistance of antibacterial properties exhibited by silver. Thus, the inventors speculate that the spectacle lens having the metal-containing layer containing the first metal and the second metal can exhibit excellent light resistance and water resistance with respect to an antibacterial property. However, the present invention is not limited to the speculations described in this specification.

[Advantageous Effects of Invention]

According to one aspect of the present invention, it is possible to provide a spectacle lens having excellent light-resistant and water-resistant antibacterial properties.

[Brief Description of Drawings]

[Fig. 1]
Fig. 1 is a schematic view for illustrating an example of a method of film-forming a metal-containing layer by a heat deposition method.

[Fig. 2]
Fig. 2 shows Specific Example 1 of temperature profiles of heaters 3A and 3B shown in Fig. 1.
[Fig. 3]
Fig. 3 shows Specific Example 2 of temperature profiles of the heaters 3A and 3B shown in Fig. 1.
[Fig. 4]
Fig. 4 shows Specific Example 3 of temperature profiles of the heaters 3A and 3B shown in Fig. 1.
[Fig. 5]
Fig. 5 is a schematic cross-sectional view showing an example of a layer structure of a spectacle lens.

[Description of Embodiments]

[Spectacle Lens and Method of Producing Spectacle Lens]

Hereinafter, the spectacle lens and the method of producing the same will be described in more detail.

<Metal-containing Layer>

The metal-containing layer of the spectacle lens contains silver (Ag) as a first metal, and one or more metals other than silver as a second metal. The second metal is one or more metals selected from the group consisting of cobalt (Co), nickel (Ni), zinc (Zn), copper (Cu), zirconium (Zr), molybdenum (Mo), lead (Pb), platinum (Pt), gold (Au) and palladium (Pd), and is preferably one or more metals selected from the group consisting of zirconium, platinum, gold and palladium. Among these, platinum is preferable because it is a metal that can contribute to controlling progress of oxidation of silver and can also exhibit an antibacterial property.

Existence forms of the first metal and the second metal in the metal-containing layer include the form of a metal alone or an alloy, the form of an inorganic compound or an organic compound, and the form of metal ions. In addition, the form of metal complexes may be exemplified. The inventors thought that at least some of silver as the first metal can be ionized by oxidation to exhibit an antibacterial property, which contributes to the metal-containing layer functioning as an antibacterial layer. In addition, the inventors thought that, when the metal that can exhibit an effect of controlling the progress of oxidation of silver as the second metal is selected, it contributes to improving light-resistant and water-resistant antibacterial properties.

The metal-containing layer is a layer that is positioned on the inorganic layer provided on the lens substrate, and can be formed on the inorganic layer by a film-forming method selected from the group consisting of a dry film-forming method and a wet film-forming method. Examples of dry film-forming methods include a physical vapor deposition method and a chemical vapor deposition method, and examples of wet film-forming methods include a coating method. In consideration of ease of forming a thin metal-containing layer film having excellent film thickness uniformity, as a method of film-forming the metal-containing layer, a dry film-forming method is preferable, and a physical vapor deposition method is more preferable. Examples of physical vapor deposition methods include a deposition method.

Hereinafter, the method of film-forming the metal-containing layer will be described using the deposition method as an example. However, the metal-containing layer is not limited to that of the film-forming method exemplified below.

In order to film-form the metal-containing layer, one or more deposition sources can be used, two or more deposition sources can be used, or two, three, or four deposition sources can be used. The total number of deposition sources to be used can be, for example, 5 or less. When the number of deposition sources to be used is 1, a deposition source containing a first metal and a second metal can be used as the one deposition source. In addition, when two or more deposition sources are used, one or more deposition sources containing only a first metal among the first metal and a second metal and one or more deposition sources containing only a second metal can be used in combination in one aspect, and two or more deposition sources containing a first metal and a second metal can be used in combination in another aspect.

A deposition source containing a first metal and/or a second metal can be produced, for example, by the following method.

A solution containing particles of silver (silver particles) as a first metal (hereinafter also referred to as a "first metal solution") is prepared. Such a solution can be, for example, an aqueous solution or a silver particle aqueous dispersion. The concentration of silver particles in the first metal solution can be, for example, in a range of 1,000 to 10,000 ppm. In the present invention and this specification, ppm is based on mass.

Separately from the above solution, a solution containing one or more types of second metal particles (hereinafter also referred to as a "second metal solution") is prepared. Such a solution can be, for example, an aqueous solution or a second metal particle aqueous dispersion. In addition, as the second metal solution, only one type of solution containing one or more types of second metal particles can be used, or two or more types of solutions containing one or more types of second metal particles can be used. In either case, the concentration of the second metal particles in the second

metal solution can be, for example, in a range of 1,000 to 10,000 ppm. Here, when the second metal solution contains two or more types of second metal particles, the concentration is a total concentration of these two or more metal particles.

As each of the above solutions, for example, a commercial product that is commercially available as a metal particle aqueous dispersion can be directly used or a commercial product that is diluted can be used.

After the solution is prepared in this manner, the solution is impregnated with a carrier. A plurality of types of solutions may be separately or simultaneously impregnated with the carrier, or a mixed solution in which a plurality of types of solutions are mixed may be impregnated with the carrier. The solution amount of the first metal solution to be impregnated with a carrier can be, for example, in a range of 0.1 to 5.0 ml. The solution amount of the second metal solution to be impregnated with a carrier can be, for example, in a range of 0.1 to 5.0 ml. In addition, when the first metal and the second metal are supported on the same carrier, the solution amount of the second metal solution is 0.1 to 5 times the solution amount of the first metal solution. Here, when two or more types of solutions are used as the second metal solution, the solution amount is a total solution amount of these two or more types of solutions.

Examples of a method of impregnating a carrier with a solution include a method of injecting or spraying a solution to a carrier and a method of immersing a carrier in a solution.

In addition, the carrier can be, for example, a porous component, and can be made of, for example, a metal, an alloy, or a ceramic. Specific examples of porous components include a sintered filter. The sintered filter can be a sintered component obtained by sintering a powder material such as a metal powder, an alloy powder, or a ceramic powder.

When the solution is impregnated with a carrier and then dried by a known method, first metal particles and second metal particles can be supported on a carrier.

The particle size of respective metal particles can be, for example, 1 nm or more and 10 nm or less or 1 nm or more and 5 nm or less.

The deposition method for film-forming the metal-containing layer can be a heat deposition method in one aspect. The heat deposition method is a method in which a deposition material is heated and vaporized by heating the internal atmosphere of a device using a heating unit (a heater, etc.) disposed in the deposition device. When a plurality of deposition sources are used in film-forming by the heat deposition method, temperature profiles for heating a plurality of deposition sources can be the same in one aspect and can be different temperature profiles in another aspect. The inventors thought that, when a plurality of deposition sources are heated according to different temperature profiles, this is preferable in order to prevent the distribution of various components in the layer to be film-formed from becoming uneven. Details are as follows.

For example, the water-repellent component to be described below generally has a different vaporization temperature from the metal component. The metal component is a component containing one or more metals, the metal component for film-forming the metal-containing layer is a component containing a first metal and/or a second metal, and it is thought that, in deposition by heating according to a single temperature profile, during temperature rise, the water-repellent component that vaporizes at a lower temperature is mainly vaporized first and deposited, and then the metal component that vaporizes at a higher temperature is mainly vaporized and deposited. Accordingly, it is thought that, when the metal component and the water-repellent component are deposited to form a metal-containing layer, the distribution of the metal component and the water-repellent component is uneven in the water-repellent layer, and regarding the water-repellent component unevenly distributed in the water-repellent layer, the water repellency that the spectacle lens can exhibit according to the inclusion of the component will be deteriorated. On the other hand, it is speculated that, regarding the property exhibited by the metal component unevenly distributed in the surface layer part, the durability is low.

On the other hand, it is thought that, when a plurality of deposition sources are heated according to different temperature profiles in the film-forming by a heat deposition method, it is possible to reduce the uneven distribution of the metal component and the water-repellent component in the layer to be film-formed. The inventors speculate that this is preferable in terms of providing a spectacle lens that can exhibit water repellency and a property exhibited by the metal component, for example, can exhibit these properties even after the surface has been worn by friction due to long term use.

When the metal-containing layer contains a water-repellent component, this layer can function as a water-repellent layer. In the present invention and this specification, the "water-repellent layer" refers to a layer that contributes to the surface of the spectacle lens exhibiting water repellency or contributes to exhibiting better water repellency than when this layer is not provided. The "water-repellent component" refers to a component that contributes to the surface of the layer containing the component exhibiting water repellency or contributes to exhibiting better water repellency than when the component is not contained.

As the water-repellent component, a fluorine-containing component may be exemplified. Examples of existence forms of fluorine in the fluorine-containing component include a form of an inorganic compound or an organic compound, and a form of an organic compound is preferable. That is, as one form of the water-repellent component, a fluorine-containing organic compound may be exemplified.

As an example of the fluorine-containing organic compound, m-xylene hexafluoride ($C_6H_4(CF_3)_2$) or the like may be exemplified.

In addition, as the fluorine-containing organic compound, for example, a fluorine-containing organic silane compound represented by the following General Formula (1) may be exemplified.

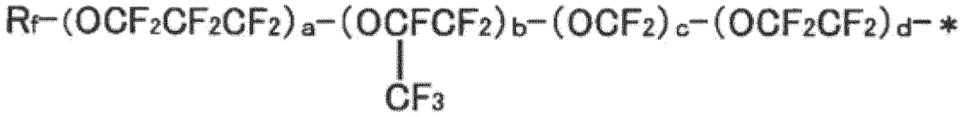

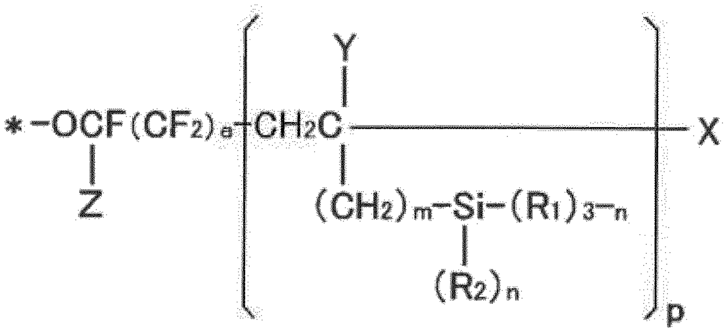

· · · (1)

In General Formula (1), Rf is a linear or branched perfluoroalkyl group having 1 to 16 carbon atoms, and preferably $CF_3$-, $C_2F_5$-, or $C_3F_7$-. $R_1$ is a hydrolyzable group, and preferably, for example, a halogen atom, $-OR_3$, $-OCOR_3$, $-OC(R_3)=C(R_4)_2$, $-ON=C(R_3)_2$, or $-ON=CR_5$, and more preferably, a chlorine atom, $-OCH_3$, or $-OC_2H_5$. Here, $R_3$ is an aliphatic hydrocarbon group or an aromatic hydrocarbon group, $R_4$ is a hydrogen atom or an aliphatic hydrocarbon group (for example, a lower aliphatic hydrocarbon group), and $R_5$ is a divalent aliphatic hydrocarbon group having 3 to 6 carbon atoms. $R_2$ is a hydrogen atom or a monovalent organic group. The monovalent organic group is preferably an inert group. The monovalent organic group is more preferably a monovalent hydrocarbon group having 1 to 4 carbon atoms. X is an iodine atom or a hydrogen atom, and Y is a hydrogen atom or an alkyl group (for example, a lower alkyl group). Z is a fluorine atom or a trifluoromethyl group. a, b, c, and d are each independently an integer in a range of 0 to 200, and preferably an integer in a range of 1 to 50. e is 0 or 1. m and n are each independently an integer in a range of 0 to 2, and preferably 0. p is an integer of 1 or more, and preferably an integer in a range of 1 to 10.

In addition, the molecular weight (weight average molecular weight Mw) of the fluorine-containing organic silane compound represented by General Formula (1) is not particularly limited, and may be, for example, a range of $5\times10^2$ to $1\times10^5$ or a range of $5\times10^2$ to $1\times10^4$.

In addition, in one aspect, the fluorine-containing organic silane compound represented by General Formula (1) may be a fluorine-containing organic silane compound represented by the following General Formula (2).

[C2]

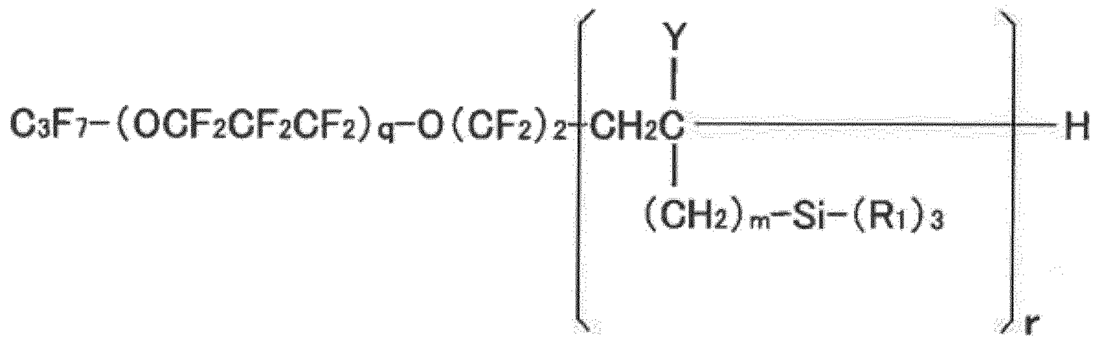

・ ・ ・ (2)

$R_1$, Y, and m in General Formula (2) have the same meanings as in General Formula (1). q is an integer in a range of 1 to 50, and r is an integer in a range of 1 to 10.

In order to film-form a metal-containing layer containing a water-repellent component, for example, a deposition method using a deposition source containing a water-repellent component can be used. The deposition method can be, for example, a heat deposition method. In order to support the water-repellent component on the carrier of the deposition source, for example, a commercially available liquid water repellent agent can be impregnated with a carrier directly or after being diluted. The amount of the solution impregnated with a carrier can be, for example, in a range of 0.10 to 5.00 ml. After impregnation, the water-repellent component can be supported on the carrier by performing drying by a known method.

When the metal-containing layer is film-formed by a heat deposition method, if a plurality of deposition sources are heated according to different temperature profiles, when three or more deposition sources are used, temperature profiles for heating at least two deposition sources may be different temperature profiles, and two or more deposition sources among three or more deposition sources may be heated according to the same temperature profile.

In one aspect, a plurality of deposition sources can be heated in one chamber. For example, using one vacuum deposition device, a plurality of deposition sources can be disposed in the vacuum chamber within this device to deposit the deposition material on a film-forming target surface.

Fig. 1 is a schematic view for illustrating an example of a method of film-forming a metal-containing layer by a heat deposition method. In Fig. 1, 2A and 2B indicate deposition sources, 3A and 3B indicate heaters, 11 indicates a lens substrate, and 14 indicates a film-formed water-repellent layer.

The pressure in the chamber during film-forming may be determined according to the type of the deposition material, and may be, for example, $2 \times 10^{-2}$ Pa or less.

As the heaters 3A and 3B, for example, a halogen heater and the like can be used. The temperature profile of the heater 3A that heats the deposition source 2A and the temperature profile of the heater 3B that heats the deposition source 2B are set to different temperature profiles. The temperature profile can be set in a control unit provided in the vacuum deposition device. The plurality of different temperature profiles can differ in one or more heating parameters selected from the group consisting of a temperature increase rate, a heating start time and a heating end time.

Fig. 2 to Fig. 4 show specific examples of temperature profiles of the heaters 3A and 3B.

Specific Example 1 shown in Fig. 2 is an example in which temperature profiles of two heaters have different temperature increase rates. For example, when the deposition source 2A heated by the heater 3A contains a water-repellent component, the deposition source 2B heated by the heater 3B contains a metal component, and the water-repellent component is a component that easily vaporizes at a lower temperature than the metal component, if a period in which the temperature increase rate of the heater 3A is slower than the temperature increase rate of the heater 3B is provided, the period during which the metal component is vaporized and the period during which the water-repellent component is vaporized can be set to the same period or the difference between these periods can be reduced. Here, the temperature increase rate for heating by each heater can be the same temperature increase rate from the start to the end of heating in one aspect, or can be changed in two or more stages from the start to the end of heating in another aspect.

Specific Example 2 shown in Fig. 3 is an example in which temperature profiles of two heaters have different temperature increase rates and heating end times. For example, when the deposition source 2A heated by the heater 3A contains a water-repellent component, the deposition source 2B heated by the heater 3B contains a metal component, and the water-repellent component is a component that easily vaporizes at a lower temperature than the metal component,

if a period during which the temperature increase rate of the heater 3A is slower than the temperature increase rate of the heater 3B is provided and heating by the heater 3B ends before heating by the heater A, the period during which the metal component is vaporized and the period during which the water-repellent component is vaporized can be set to the same period or the difference between these periods can be reduced.

Specific Example 3 shown in Fig. 4 is an example in which temperature profiles of two heaters have different heating start times and temperature increase rates. For example, when both the deposition source 2A heated by the heater 3A and the deposition source 2B heated by the heater 3B contain a metal component and a water-repellent component, according to Specific Example 3, since the period during which the water-repellent component is vaporized from the deposition source 2A and the period during which the water-repellent component is vaporized from the deposition source 2B can be made different, and the period during which the metal component is vaporized from the deposition source 2A and the period during which the metal component is vaporized from the deposition source 2B can be made different, it is possible to reduce the uneven distribution of the water-repellent component and the metal component in the formed water-repellent layer.

However, Specific Examples 1 to 3 are only examples, and the present invention is not limited to such examples.

The maximum heating temperature in the temperature profile may be determined according to the type of the deposition material, and can be, for example, 100°C or higher and 750°C or lower, but the temperature is not limited to this range.

The film thickness of the metal-containing layer thus formed can be, for example, 30 nm or less, 25 nm or less, 20 nm or less or 15 nm or less. The film thickness of the metal-containing layer can be, for example, 5 nm or more or 10 nm or more. In addition, when the metal-containing layer is a layer that can function as a water-repellent layer, a contact angle with respect to water on the surface of the layer can be, for example, 100° or more and 120° or less. The water-repellent layer can be provided, for example, as the outermost layer on one side or both sides of the spectacle lens.

<Example of Layer Structure of Spectacle Lens>

The spectacle lens has the metal-containing layer on the side of the surface opposite to the lens substrate of the inorganic layer. The metal layer can be provided directly on the surface of the inorganic layer or indirectly with another layer therebetween.

Fig. 5 is a schematic cross-sectional view showing an example of a layer structure of the spectacle lens. A spectacle lens 1 shown in Fig. 5 has a hard coat layer 12 on one surface 11a (for example, an object-side surface) of the lens substrate 11 and a multilayer film 13 thereon. The multilayer film 13 is a film in which low-refractive-index layers 13L and high-refractive-index layers 13H are alternately laminated. The metal-containing layer 14 is provided on the surface of the multilayer film. The metal-containing layer 14 can function as an antibacterial layer, and additionally can function as a water-repellent layer when it contains a water-repellent component.

<Lens Substrate>

The lens substrate of the spectacle lens can be a plastic lens substrate or a glass lens substrate. The glass lens substrate can be, for example, a lens substrate made of inorganic glass. The lens substrate is preferably a plastic lens substrate because it is light-weight, hard to break and easy to handle. Examples of plastic lens substrates include styrene resins such as (meth)acrylic resins, allyl carbonate resins such as a polycarbonate resin, allyl resin, and diethylene glycol bisallyl carbonate resin (CR-39), vinyl resins, polyester resins, polyether resins, urethane resins obtained by reacting an isocyanate compound and a hydroxy compound such as diethylene glycol, thiourethane resins obtained by reacting an isocyanate compound and a polythiol compound, and a cured product obtained by curing a curable composition containing a (thio)epoxy compound having one or more disulfide bonds in the molecule (generally referred to as a transparent resin). As the lens substrate, an undyed substrate (colorless lens) may be used or a dyed substrate (dyed lens) may be used. The refractive index of the lens substrate can be, for example, about 1.60 to 1.75. However, the refractive index of the lens substrate is not limited to the above range, and may be within the above range or may be above or below outside the above range. In the present invention and this specification, the refractive index refers to a refractive index for light having a wavelength of 500 nm. In addition, the lens substrate may be a lens having refractive power (so-called prescription lens) or a lens having no refractive power (so-called non-prescription lens).

The spectacle lens may include various lenses such as a single focus lens, a multifocal lens, and progressive power lens. The type of the lens is determined by the surface shape of both sides of the lens substrate. In addition, the surface of the lens substrate may be a convex surface, a concave surface, or a flat surface. In a general lens substrate and spectacle lens, the object-side surface is a convex surface, and the eyeball-side surface is a concave surface. However, the present invention is not limited thereto.

<Inorganic Layer>

The spectacle lens has an inorganic layer on the lens substrate. In the present invention and this specification, the "inorganic layer" is a layer containing an inorganic substance and preferably a layer containing an inorganic substance as a main component. Here, the main component is a component whose proportion is the largest in the layer and is a component whose proportion is generally about 50 mass% to 100 mass%, and additionally about 90 mass% to 100 mass% with respect to the mass of the layer. The same applied to main components to be described below. The inorganic layer can be a layer that is directly laminated on the surface of the lens substrate or a layer that is indirectly laminated on the surface of the lens substrate with one or more other layers therebetween. Examples of other layers include one or more known layers such as a cured layer of a curable composition generally called a hard coat layer and a primer layer provided for improving adhesion. The types and film thicknesses of these layers are not particularly limited, and can be determined according to desired functions and optical properties of the spectacle lens.

In one aspect, the inorganic layer can be a multilayer film composed of two or more inorganic layers. When the inorganic layer is a multilayer film, the metal-containing layer is provided on the uppermost inorganic layer (that is, an inorganic layer at a position most distant from the lens substrate) of the multilayer film. Examples of such a multilayer film include a multilayer film including one or more high-refractive-index layers and one or more low-refractive-index layers. Such a multilayer film may be an antireflection film having a property of preventing reflection of light having a specific wavelength or light in a specific wavelength range or a reflection film having a property of reflecting light having a specific wavelength or light in a specific wavelength range. Such an inorganic layer is, for example, the multilayer film 13 shown in Fig. 5. In the present invention and this specification, "high" and "low" for the "high refractive index" and "low refractive index" are relative terms. That is, the high-refractive-index layer is a layer having a higher refractive index than the low-refractive-index layer included in the same multilayer film. In other words, the low-refractive-index layer is a layer having a lower refractive index than the high-refractive-index layer included in the same multilayer film. The refractive index of the high-refractive-index material constituting the high-refractive-index layer can be, for example, 1.60 or more (for example, in a range of 1.60 to 2.40), and the refractive index of the low-refractive-index material constituting the low-refractive-index layer can be, for example, 1.59 or less (for example, in a range of 1.37 to 1.59). However, as described above, since "high" and "low" for the high refractive index and the low refractive index are relative terms, the refractive indices of the high-refractive-index material and the low-refractive-index material are limited to the above ranges.

Specifically, examples of high-refractive-index materials for forming a high-refractive-index layer include mixtures of one, two or more oxides selected from the group consisting of zirconium oxide (for example, $ZrO_2$), tantalum oxide (for example, $Ta_2O_5$), titanium oxide (for example, $TiO_2$), aluminum oxide (for example, $Al_2O_3$), yttrium oxide (for example, $Y_2O_3$), hafnium oxide (for example, $HfO_2$), and niobium oxide (for example, $Nb^2O_5$). On the other hand, examples of low-refractive-index materials for forming a low-refractive-index layer include mixtures of one, two or more oxides or fluorides selected from the group consisting of silicon oxide (for example, $SiO_2$), magnesium fluoride (for example, $MgF_2$) and barium fluoride (for example, $BaF_2$). In the above examples, for convenience, oxides and fluorides are indicated by stoichiometric compositions, but those in which oxygen or fluorine is deficient or excessive from the stoichiometric composition can be used as the high-refractive-index material or the low-refractive-index material.

Preferably, the high-refractive-index layer is a film containing a high-refractive-index material as a main component, and the low-refractive-index layer is a film containing a low-refractive-index material as a main component. Such a film (for example, a deposition film) can be formed by film-formation using a film-forming material (for example, a deposition material) containing the high-refractive-index material or the low-refractive-index material as a main component. Films and film-forming materials may contain impurities that are inevitably mixed, and may contain other components to the extent that functions of the main component are not impaired, for example, other inorganic substances and known additive components that assist film-formation. Film formation can be performed by a known film-forming method, and in consideration of ease of film-formation, film-formation is preferably performed by deposition and more preferably performed by vacuum deposition. The antireflection film can be, for example, a multilayer film in which a total of 3 to 10 layers of high-refractive-index layers and low-refractive-index layers are alternately laminated. The film thickness of the high-refractive-index layer and the film thickness of the low-refractive-index layer can be determined according to the layer structure. Specifically, a combination of layers included in the multilayer film and the film thickness of each layer can be determined by an optical design simulation using a known technique based on the refractive index of the film-forming material for forming a high-refractive-index layer and a low-refractive-index layer, and a desired reflection property and transmission property for the spectacle lens according to provision of the multilayer film. In addition, the multilayer film may include a layer containing a conductive oxide as a main component (conductive oxide layer), and preferably one or more layers of a deposition film of a conductive oxide formed by deposition using a deposition material containing a conductive oxide as a main component at an arbitrary position. The film thickness of each of the high-refractive-index layer and the low-refractive-index layer included in the multilayer film can be, for example, 3 to 500 nm, and the total thickness of the multilayer film can be, for example, 100 to 900 nm. In the present invention and this specification, the

film thickness is a physical film thickness.

In the spectacle lens, the metal-containing layer is provided on the surface of the inorganic layer. The metal-containing layer can be a layer that is directly laminated on the surface of the inorganic layer or a layer that is indirectly laminated on the surface of the inorganic layer with one or more other layers therebetween. For the other layers, the above description can be referred to.

A laminate including at least the inorganic layer and the metal-containing layer can be formed on at least one surface of the lens substrate or can be formed on both surfaces thereof. For example, the laminate can be positioned on the object side of the spectacle lens, the laminate can be positioned on the eyeball side of the spectacle lens, and the laminate can be positioned on the object side and the eyeball side of the spectacle lens. When the laminate is positioned on both sides of the spectacle lens, the laminate on the object side and the laminate on the eyeball side can be the same laminate or different laminates. In the present invention and this specification, the "eyeball side" is the side of the surface positioned on the eyeball side when spectacles having spectacle lenses are worn by a wearer. The "object side" is the side of the surface opposite thereto, that is, the side of the surface positioned on the object side when spectacles having spectacle lenses are worn by a wearer.

In the spectacle lens, the metal-containing layer can function as an antibacterial layer, and thereby antibacterial properties can be exhibited. In addition, when the metal-containing layer is a layer that can also function as a water-repellent layer, the spectacle lens can exhibit water repellency, and thereby, for example, water discoloration of the lens and the like can be prevented. The inorganic layer functions, for example, as an antireflection film, and thus a spectacle lens can have an antireflection property with respect to light having a specific wavelength or light in a specific wavelength range.

[Spectacles]

One aspect of the present invention relates to spectacles having the spectacle lens. The details of the spectacle lens included in the spectacles are as described above. Regarding the spectacles, a known technique can be applied to the configuration of the frame and the like.

[Examples]

Hereinafter, the present invention will be described in more detail with reference to examples. However, the present invention is not limited to embodiments shown in examples.

In the following description, the $SiO_2$ layer is a deposition film-formed using silicon oxide as a deposition material, and the $ZrO_2$ layer is a deposition film-formed using zirconium oxide as a deposition material. Each deposition material is a deposition material composed of only the described oxides, except for inevitably mixed impurities.

[Example 1]

<Production of Lens Substrate with Hard Coat Layer>

A hard coat liquid containing inorganic oxide particles and a silicon compound was applied to the entire object-side surface (convex surface) of a plastic lens substrate produced using a spectacle lens monomer (MR8 commercially available from Mitsui Chemicals, Inc.) by spin coating, and cured by heating in a heating furnace with an internal temperature of 100°C for 60 minutes, and thereby a single hard coat layer having a film thickness of 3 um was formed.

<Production of Multilayer Antireflection Film>

Next, the lens substrate with the hard coat layer formed thereon was put into a vacuum deposition device, and a multilayer antireflection film in which a total of 7 layers including "$SiO_2$ layer/$ZrO_2$ layer/$SiO_2$ layer/$ZrO_2$ layer/$SiO_2$ layer/$ZrO_2$ layer/$SiO_2$ layer" (total thickness: about 400 to 600 nm) was laminated on the entire hard coat layer surface by a vacuum deposition method was formed. The notation "/" indicates that the part described in the left of "/" and the part described to the right are directly laminated. This point also applies to the following description.

Thereby, a spectacle lens having a layer structure of "lens substrate/hard coat layer/multilayer antireflection film (inorganic layer)" was produced.

<Film-formation of Water-repellent Layer>

(Production of Deposition Source)

As a water-repellent component solution, a water repellent agent (product name: KY-130, containing a fluorine-containing organic silane compound, commercially available from Shin-Etsu Silicones) was used.

As a first metal component solution, an aqueous dispersion containing silver particles having a particle size of 2 to 5 nm at a concentration of 5,000 ppm was prepared.

As a second metal component solution, an aqueous dispersion containing platinum particles having a particle size of 2 to 5 nm at a concentration of 5,000 ppm was prepared.

A disk-shape sintered filter (material: SUS) with a diameter of 18 mm was used as a deposition source carrier, and two deposition sources were produced by the following method.

A carrier injected with the water-repellent component solution in the amount shown in Table 1 was dried in a drying furnace with an internal temperature of 50°C for 1 hour.

The carrier after the drying treatment was subjected to a drying treatment in a drying furnace with an internal temperature of 50°C for 1 hour after a metal component solution containing a first metal in the amount shown in Table 1 was injected.

The carrier after the drying treatment was subjected to a drying treatment in a drying furnace with an internal temperature of 50°C for 1 hour after a metal component solution containing a second metal in the amount shown in Table 1 was injected.

Accordingly, two deposition sources in which the water-repellent component, the first metal (Ag) component and the second metal (Pt) component were supported on the carrier were produced.

(Film-formation of Water-repellent Layer by Heat Deposition Method)

As shown in Fig. 1, in the vacuum chamber of the vacuum deposition device, the spectacle lens with the multilayer antireflection film-formed thereon and the deposition source were disposed. The two deposition sources produced above were disposed in the deposition sources 2A and 2B. Each deposition source was mounted on a molybdenum boat (not shown in Fig. 1) and disposed in the vacuum chamber. The pressure in the vacuum chamber was set to $2\times10^{-2}$ Pa or less, and heating was performed by the heater 3A and the heater 3B (both a halogen heater) according to the temperature profile of Specific Example 3 in Fig. 4. Specifically, in the temperature profile of the heater 3A, the temperature was raised to 600°C over 1 minute and 30 seconds and the temperature was then raised from 600°C to 650°C over 4 minutes and 30 seconds. In the temperature profile of the heater 3B, the heating start time was delayed by 1 minute and 30 seconds from the heating start time of the heater 3A, the temperature was raised to 600°C over 2 minutes and the temperature was then raised from 600°C to 650°C over 4 minutes. When heating was performed in this manner, the water-repellent component, the first metal component and the second metal component could be heated and vaporized, and a deposition film in which the water-repellent component, the first metal component and the second metal component were deposited on the surface of the multilayer antireflection film could be formed.

Accordingly, a water-repellent layer containing the water-repellent component and two metal components and having a film thickness of 10 to 20 nm was film-formed on the surface of the multilayer antireflection film.

According to the above processes, a spectacle lens of Example 1 having a layer structure of "lens substrate/hard coat layer/multilayer antireflection film (inorganic layer)/water-repellent layer (metal-containing layer)" was produced.

[Comparative Example 1]

A spectacle lens of Example 2 was produced by the method described in Example 1 except that no second metal component solution was used when the deposition source was produced.

Table 1 shows the amounts of various solutions injected into the carrier when the deposition source was produced for Example 1 and Comparative Example 1.

[Antibacterial Property Test]

The antibacterial property test was performed according to JIS Z 2801: 2012. In the antibacterial property test of the spectacle lenses of Example 1 and Comparative Example 1, a spectacle lens produced in the same method as the spectacle lens of each example or comparative example except that the metal-containing layer was not formed was used as a reference sample.

Regarding light-resistant antibacterial properties, a test piece cut out from each spectacle lens was subjected to a light resistance test in Category 1 described in the chapter of the light resistance test according to a sustainability test method (2018 version) in The Society of International sustaining growth for Antimicrobial Articles (SIAA), and antibacterial properties were then evaluated by the following method.

Regarding water-resistant antibacterial properties, a test piece cut out from each spectacle lens was subjected to a water resistance test in Category 1 described in the chapter of the water resistance test according to a sustainability test method (2018 version) in The Society of International sustaining growth for Antimicrobial Articles (SIAA), and antibacterial properties were then evaluated by the following method.

A 50 mm×50 mm test piece (a test piece cut out from each spectacle lens of the example and comparative example and its reference sample) was placed in a sterilized petri dish, and 0.4 mL of a bacteria solution containing $1.0\times10^5$ to $4.0\times10^5$ test bacteria (Staphylococcus aureus or Escherichia coli) was then added dropwise to the center of the test piece, and covering with a polyethylene film cut to 40 mm×40 mm was performed. After culturing was performed in the petri dish at a relative humidity of 90% or more for 24 hours, the number of viable bacteria per 1 $cm^2$ was measured, and the following antibacterial activity value was calculated.
Antibacterial activity value=Ut-At≥2.0

Ut: average value of the logarithmic value of the number of viable bacteria per 1 $cm^2$ after the unprocessed test piece (reference sample) was cultured for 24 hours
At: average value of the logarithmic value of the number of viable bacteria per 1 $cm^2$ after the antibacterial treated test piece (example or comparative example sample) was cultured for 24 hours

The Society of International sustaining growth for Antimicrobial Articles (SIAA) defines that the product has an antibacterial effect if the antibacterial activity value is 2 or more. Therefore, the antibacterial properties of the spectacle lenses of Example 1 and Comparative Example 1 after the light resistance test or the water resistance test were determined from the antibacterial activity value obtained above based on the following determine criteria.

OK: the antibacterial activity value was 2.0 or more
NG: the antibacterial activity value was less than 2.0

Table 2 shows the above results.

[Table 1]

| | First deposition source | | | Second deposition source | | |
|---|---|---|---|---|---|---|
| | Water-repellent component | First metal component | Second metal component | Water-repellent component | First metal component | Second metal component |
| Example 1 | 0.125ml | 1.0ml | 1.5ml | 0.125ml | 1.0ml | 1.5ml |
| Comparative Example 1 | 0.125ml | 1.0ml | - | 0.125ml | 1.0ml | - |

[Table 2]

| | Antibacterial property: Staphylococcus aureus | | Antibacterial property: Escherichia coli | |
|---|---|---|---|---|
| | Water resistance | Light resistance | Water resistance | Light resistance |
| Example 1 | OK | OK | OK | OK |
| Comparative Example 1 | OK | NG | NG | NG |

Based on the results shown in Table 1, it was confirmed that the spectacle lens of Example 1 having a metal-containing layer containing a second metal together with a first metal had better light-resistant and water-resistant antibacterial properties than the spectacle lens of Comparative Example 1 in which the metal-containing layer did not contain a second metal.

[Measurement of Contact Angle at Initial Stage and After Friction Wear Treatment]

For the spectacle lens of Example 1, the contact angle of the spectacle lens without a friction wear treatment (initial) and after the friction wear treatment was measured by the following method. The initial contact angle was 108 degrees, and the contact angle after the friction wear treatment was 106 degrees. Based on the results, it was confirmed that the spectacle lens of Example 1 had a large contact angle value and excellent water repellency both at the initial stage and after the friction wear treatment.

(Friction Wear Treatment)

The friction wear treatment was performed by the following method. An eraser cut to a size of 19 mm×24 mm and wrapped with lens wiping paper (Dusper commercially available from Ozu Corporation) was attached to a reciprocating friction wear tester (Tribogear 30S, commercially available from Yamato Scientific Co., Ltd.) as a friction wear member. The surface of the water-repellent layer of the spectacle lens was rubbed back and forth 5,000 times with a friction wear member with a load of 2 kg.

(Measurement of Contact Angle)

Using a CA-D model (commercially available from Kyowa Interface Science Co., Ltd.) as a contact angle meter, in a measurement environment with an atmosphere temperature of 25°C, a water droplet with a diameter of 2 mm was formed at the needle tip, and this was brought into the top of the convex surface of the metal-containing layer of the spectacle lens to form a droplet. The angle between the droplet and the surface generated in this case was measured and used as a static contact angle. The contact angle was measured within 10 seconds after the water droplet was brought into contact with the spectacle lens in order to minimize measurement errors due to water evaporation. The static contact angle $\theta$ was determined by the following formula, where r is the radius of the water droplet (radius of a part in which water droplets were brought into contact with the surface of the spectacle lens) and h is the height of the water droplet.

$$\theta=2\times\tan^{-1}(h/r)$$

Finally, the above respective aspects are summarized.

According to one aspect, there is provided a spectacle lens including a lens substrate and an inorganic layer, and further including a metal-containing layer on the side of the surface of the inorganic layer opposite to the lens substrate, wherein a metal contained in the metal-containing layer includes a first metal and a second metal, wherein the first metal is silver, and wherein the second metal is one or more metals selected from the group consisting of cobalt, nickel, zinc, copper, zirconium, molybdenum, lead, platinum, gold and palladium.

The spectacle lens may be a spectacle lens having excellent light-resistant and water-resistant antibacterial properties.

In one aspect, the second metal may be one or more metals selected from the group consisting of zirconium, platinum, gold and palladium.

In one aspect, the second metal may include platinum.

In one aspect, the inorganic layer may be a multilayer film composed of two or more inorganic layers.

In one aspect, the metal-containing layer may be a water-repellent layer.

In one aspect, the water-repellent layer may contain a fluorine-based organic compound.

According to one aspect, there is provided a method of producing the spectacle lens, including film-forming the metal-containing layer by a heat deposition method and heating a plurality of deposition sources according to different temperature profiles in the film-forming by the heat deposition method.

In one aspect, in the different temperature profiles, one or more heating parameters selected from the group consisting of a temperature increase rate, a heating start time and a heating end time may be different.

According to one aspect, there is provided spectacles having the spectacle lens.

Two or more of various aspects and various forms described in this specification can be combined in arbitrary combinations.

The embodiments disclosed herein are only examples in all respects and should not be considered as restrictive. The scope of the present invention is not limited to the above description, but is defined by the scope of claims, and is intended to encompass equivalents to the scope of claims and all modifications within the scope of the claims.

[Industrial Applicability]

One aspect of the present invention is beneficial in the field of producing spectacle lenses and spectacles.

## Claims

1. A spectacle lens, comprising

a lens substrate and an inorganic layer,
further comprising
a metal-containing layer on the side of the surface of the inorganic layer opposite to the lens substrate,
wherein a metal contained in the metal-containing layer includes a first metal and a second metal,
wherein the first metal is silver, and
wherein the second metal is one or more metals selected from the group consisting of cobalt, nickel, zinc, copper, zirconium, molybdenum, lead, platinum, gold and palladium.

**2.** The spectacle lens according to claim 1,
wherein the second metal is one or more metals selected from the group consisting of zirconium, platinum, gold and palladium.

**3.** The spectacle lens according to claim 1 or 2,
wherein the second metal includes platinum.

**4.** The spectacle lens according to any one of claims 1 to 3,
wherein the inorganic layer is a multilayer film composed of two or more inorganic layers.

**5.** The spectacle lens according to any one of claims 1 to 4,
wherein the metal-containing layer is a water-repellent layer.

**6.** The spectacle lens according to claim 5,
wherein the water-repellent layer contains a fluorine-based organic compound.

**7.** A method of producing the spectacle lens according to any one of claims 1 to 6, the method comprising:

film-forming the metal-containing layer by a heat deposition method; and
heating a plurality of deposition sources according to different temperature profiles in the film-forming by the heat deposition method.

**8.** The method of producing a spectacle lens according to claim 7,
wherein, in the different temperature profiles, one or more heating parameters selected from the group consisting of a temperature increase rate, a heating start time and a heating end time are different.

**9.** Spectacles comprising the spectacle lens according to any one of claims 1 to 6.

[Fig. 1]

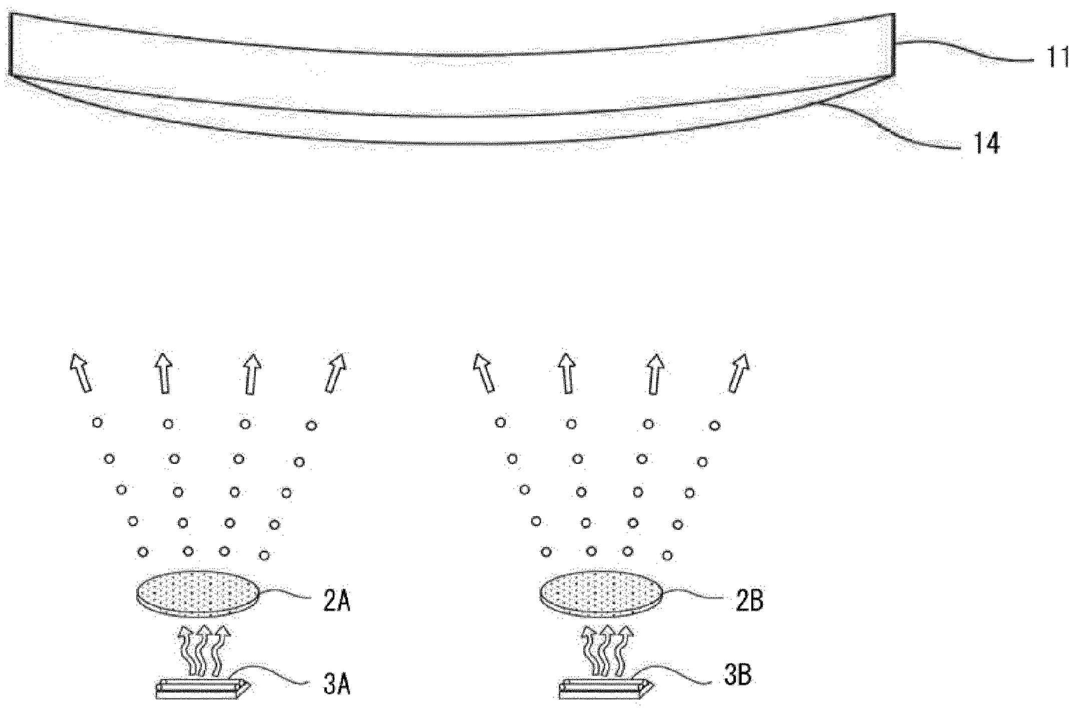


[Fig. 2]

(REFERENCE EXAMPLE 1)

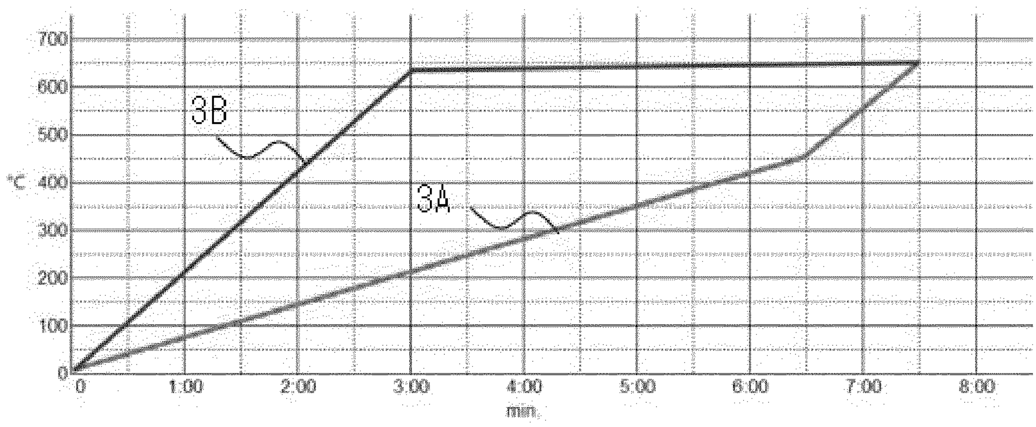

[Fig. 3]

(REFERENCE EXAMPLE 2)

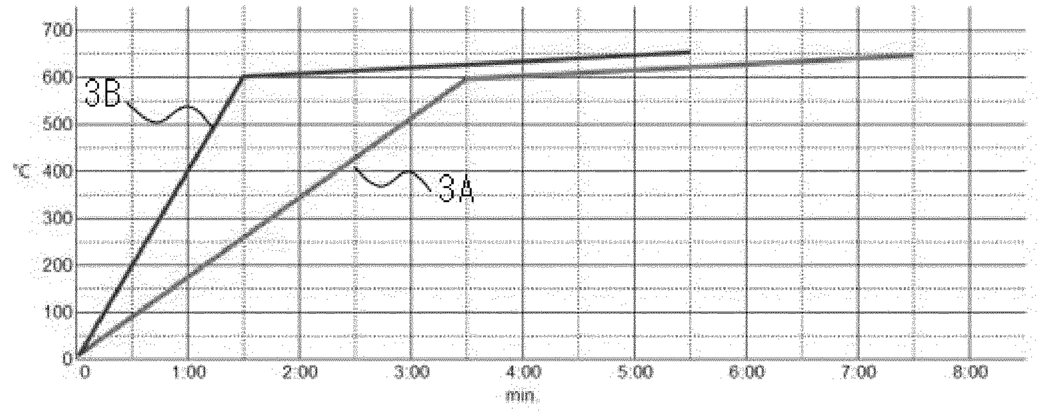


[Fig. 4]

(REFERENCE EXAMPLE 3)

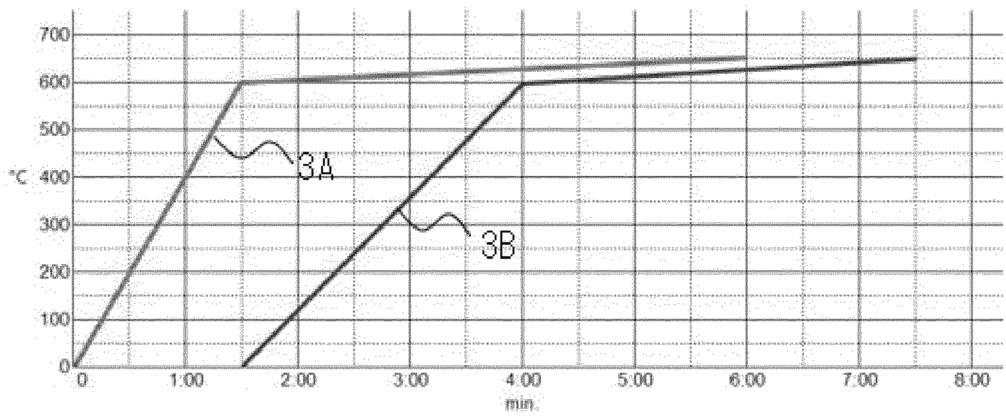

[Fig. 5]

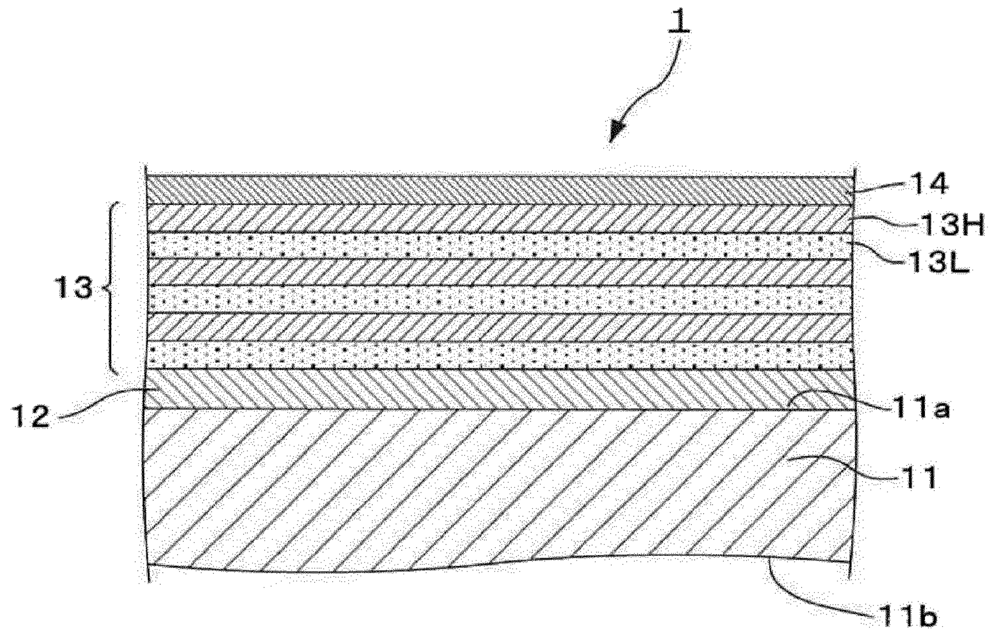

## INTERNATIONAL SEARCH REPORT

International application No.
**PCT/JP2021/048731**

### A. CLASSIFICATION OF SUBJECT MATTER

***G02C 7/00***(2006.01)i; ***C23C 14/12***(2006.01)i; ***C23C 14/14***(2006.01)i; ***G02B 1/115***(2015.01)i; ***G02B 1/18***(2015.01)i
FI: G02C7/00; G02B1/18; G02B1/115; C23C14/12; C23C14/14 D

According to International Patent Classification (IPC) or to both national classification and IPC

### B. FIELDS SEARCHED

Minimum documentation searched (classification system followed by classification symbols)

G02C7/00; C23C14/12; C23C14/14; G02B1/115; G02B1/18

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br>Y | JP 2006-184849 A (TOPPAN PRINTING CO LTD) 13 July 2006 (2006-07-13) paragraphs [0032]-[0033], [0055], example 1 | 1-4, 9<br>1-9 |
| Y | JP 2018-159860 A (TOKAI KOGAKU KK) 11 October 2018 (2018-10-11) claims, paragraphs [0009], [0017]-[0019], examples, examination example 7 | 1-9 |
| X | JP 10-221504 A (TOTO LTD) 21 August 1998 (1998-08-21) claims, paragraphs [0006], [0011]-[0012] | 1-6, 9 |
| Y | JP 2011-107510 A (KONICA MINOLTA OPTO INC) 02 June 2011 (2011-06-02) claims, paragraphs [0033]-[0034], examples 1-6 | 5-8 |
| Y | JP 5-112658 A (ORIHARA, Katsuo) 07 May 1993 (1993-05-07) paragraphs [0018]-[0026] | 8 |
| Y | Microfilm of the specification and drawings annexed to the request of Japanese Utility Model Application No. 057132/1979 (Laid-open No. 159869/1980) (RICOH COMPANY, LTD) 17 November 1980 (1980-11-17), p. 1, lines 14-16, p. 3, line 8 to p. 4, line 4, fig. 2 | 8 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **18 February 2022** | **08 March 2022** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**

International application No.
**PCT/JP2021/048731**

**C. DOCUMENTS CONSIDERED TO BE RELEVANT**

| Category* | Citation of document, with indication, where appropriate, of the relevant passages | Relevant to claim No. |
|---|---|---|
| A | JP 62-1858 A (TOYO METARAIJINGU KK) 07 January 1987 (1987-01-07) entire text | 1-9 |
| A | JP 2007-187780 A (TOPPAN PRINTING CO LTD) 26 July 2007 (2007-07-26) entire text, all drawings | 1-9 |
| P, A | WO 2021/060554 A1 (HOYA LENS THAILAND LTD) 01 April 2021 (2021-04-01) entire text, all drawings | 1-9 |

Form PCT/ISA/210 (second sheet) (January 2015)

**INTERNATIONAL SEARCH REPORT**
**Information on patent family members**

International application No.
**PCT/JP2021/048731**

| Patent document cited in search report | Publication date (day/month/year) | Patent family member(s) | Publication date (day/month/year) |
|---|---|---|---|
| JP 2006-184849 A | 13 July 2006 | (Family: none) | |
| JP 2018-159860 A | 11 October 2018 | (Family: none) | |
| JP 10-221504 A | 21 August 1998 | (Family: none) | |
| JP 2011-107510 A | 02 June 2011 | (Family: none) | |
| JP 5-112658 A | 07 May 1993 | (Family: none) | |
| JP 55-159869 U1 | 17 November 1980 | (Family: none) | |
| JP 62-1858 A | 07 January 1987 | (Family: none) | |
| JP 2007-187780 A | 26 July 2007 | (Family: none) | |
| WO 2021/060554 A1 | 01 April 2021 | JP 2021-56327 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2003014904 A